Europäisches Patentamt

(19) European Patent Office

Office européen des brevets

(11) Numéro de publication: **0 331 578**
A1

## (12) DEMANDE DE BREVET EUROPEEN

(21) Numéro de dépôt: **89400571.9**

(22) Date de dépôt: **01.03.89**

(51) Int. Cl.⁴: **C 04 B 35/46**
H 01 B 3/12, H 01 G 4/12

(30) Priorité: **02.03.88 FR 8802635**

(43) Date de publication de la demande:
**06.09.89 Bulletin 89/36**

(84) Etats contractants désignés: **DE GB**

(71) Demandeur: **COMMISSARIAT A L'ENERGIE ATOMIQUE**
**31/33, rue de la Fédération**
**F-75015 Paris (FR)**

(72) Inventeur: **Ravez, Jean**
**9, allée de Perliguey**
**33850 Leognan (FR)**

**Miane Jean Louis**
**Les Terrasses, Bt5F, rue H.de Montherlant**
**33400 Talence (FR)**

**Bonnet, Jean Pierre**
**rue de Aureau**
**33360 Carignan (FR)**

**Simon Annie**
**90, rue Robespierre**
**33400 Talence (FR)**

(74) Mandataire: **Des Termes, Monique et al**
**Société Brevatome 25, rue de Ponthieu**
**F-75008 Paris (FR)**

(54) Composition céramique diélectrique utilisable en hautes fréquences et en hyperfréqences et son procédé de fabrication.

㊵ Composition céramique diélectrique performante en hautes fréquences et en hyperfréquences et son procédé de fabrication.

On prépare un mélange de $SrCO_3$, $TiO_2$ et $Nb_2O_5$ (ou $Ta_2O_5$), le rapport molaire Ti/Sr allant de 1,01 à 1,10 et de préférence de 1,01 à 1,02 et la quantité de $Nb_2O_5$ (ou $Ta_2O_5$) étant de 0,04 à 5% en moles. Par chamottage de ce mélange, on obtient une poudre de type perovskite qui est pressée et frittée sous atmosphère réductrice afin d'obtenir une pastille semi-conductrice. Celle-ci est ensuite imprégnée d'un fondant $B_2O_3$ qui formera une couche d'arrêt intergranulaire après réoxydation à l'air de la pastille.

Application à la réalisation de matériaux aptes à absorber les hautes fréquences et les hyperfréquences.

EP 0 331 578 A1

Description

## COMPOSITION CERAMIQUE DIELECTRIQUE UTILISABLE EN HAUTES FREQUENCES ET EN HYPERFREQUENCES ET SON PROCEDE DE FABRICATION

La présente invention a pour objet une composition céramique diélectrique pouvant être utilisée comme revêtement protecteur absorbant les hautes fréquences, soit les fréquences de 10 à 500 MHz, et les hyperfréquences, soit les fréquences supérieures à 500 MHz.

L'élimination d'interférences et d'échos fixes générés par des sources ou des parasitages hyperfréquence peut être obtenue au moyen de revêtements protecteurs absorbants.

Pour ce faire, ces revêtements doivent avoir un coefficient de réflexion nul ou, en tout cas, voisin de zéro. Pour une épaisseur déterminée de matériau, cette valeur du coefficient de réflexion s'obtient en calculant à l'aide des équations de propagation les valeurs des constantes diélectriques réelles $\varepsilon'_r$ et imaginaire $\varepsilon''_r$ que doit posséder le matériau utilisé pour le revêtement.

Une solution possible serait d'avoir une valeur élevée de $\varepsilon'_r$ et un facteur de pertes $\varepsilon''_r/\varepsilon'_r$ de l'ordre de 0.1 à 0.5. De telles valeurs permettraient d'avoir des épaisseurs de l'ordre de 1 mm. A l'heure actuelle, un certain nombre de matériaux présente des valeurs de $\varepsilon'_r$ élevées. Une première catégorie de tels matériaux est constituée par les céramiques à base de titanates alcalino-terreux de structure perovskite $MTiO_3$, M désignant un métal alcalino-terreux tel que le calcium, le strontium ou le baryum. Ces matériaux sont des céramiques à grains isolants. Les valeurs de $\varepsilon'_r$ de ces matériaux sont généralement comprises entre 100 et 1000 et le rapport $\varepsilon''_r/\varepsilon'_r$ est de l'ordre de 0,001. Cette valeur trop faible du facteur de pertes les rend impropres à la réalisation de revêtements absorbants. Ils sont par contre utilisés en hyperfréquences comme résonateurs diélectriques.

Une autre catégorie de matériaux présentant des valeurs de $\varepsilon'_r$ élevées est constituée par les conducteurs organiques complexes à transfert de charge tels que TTF ou TCNQ (tétrathiofulvalène ou tétracyanoquinodiméthane) ou des sels d'ions radicaux tels que $TMTTF_2X$ où X est un cation monovalent (TM = tétraméthyl). Ces matériaux possèdent également des valeurs de $\varepsilon'_r$ très élevées en hautes fréquences et en hyperfréquences. Cependant, ces matériaux sont difficiles à synthétiser et, d'autre part, ils présentent des valeurs de $\varepsilon''_r$ trop élevées, c'est-à-dire que le matériau est trop conducteur. Pour ces matériaux, le rapport $\varepsilon''_r/\varepsilon'_r$ est supérieur à 1.

Une autre famille de matériaux est connue pour posséder en basses fréquences des valeurs de constante diélectrique $\varepsilon'_r$ très élevées (supérieures à 50000) et des valeurs de $\varepsilon''_r$ relativement faibles telles que le rapport $\varepsilon''_r/\varepsilon'_r$ est de l'ordre de $2.10^{-2}$. Ces matériaux sont des diélectriques à couches d'arrêt à base de grains semi-conducteurs de type $MTiO_3$, M étant un métal alcalino-terreux, de préférence du strontium. Des céramiques semi-conductrices à couches d'arrêt de ce type sont décrites en particulier dans les brevets FR-A-2 339 235 et US-A-3 933 668, et dans le document J. Am. Ceram. Soc. (68(4) 169-173 (1985). Dans ces matériaux, le titanate de strontium est rendu semi-conducteur par addition de $Nb_2O_5$ ou $Ta_2O_5$ et la couche d'arrêt est formée à partir de mélanges de substances telles que $Bi_2O_3$, $MnO_2$ et $Li_2CO_3$. Cependant, l'utilisation de ces céramiques est limitée aux basses fréquences (de l'ordre du kilohertz) car, comme on va le voir ci-après, les valeurs de $\varepsilon'_r$ diminuent lorsque la fréquence augmente.

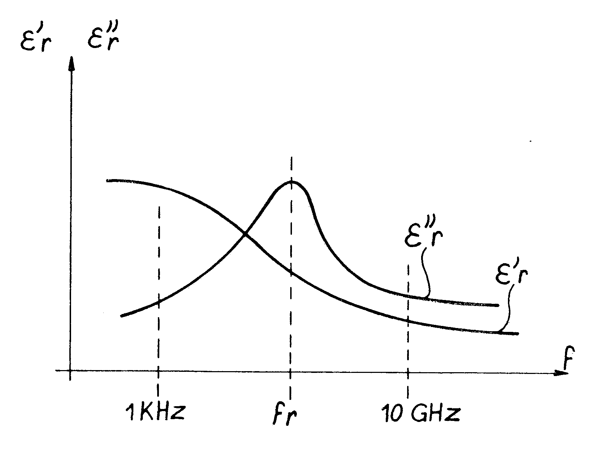

La figure ci-jointe est un graphe donnant un exemple d'allure générale de la variation des valeurs de $\varepsilon'_r$ et $\varepsilon''_r$ pour un matériau donné en fonction de la fréquence. En ce qui concerne $\varepsilon'_r$, on voit que la valeur est élevée pour des basses fréquences (de l'ordre du kilohertz), puis s'abaisse et se stabilise à un niveau relativement faible pour des hautes fréquences et des hyperfréquences, c'est-à-dire pratiquement aux environs du GHz et au-delà. En ce qui concerne $\varepsilon''_r$, on voit que la valeur est faible aux basses fréquences (de l'ordre du kilohertz), puis passe par un maximum et diminue ensuite lorsqu'on atteint la gamme des hautes fréquences. La valeur $f_r$ de la fréquence correspondant au maximum de $\varepsilon''_r$ est appelée "fréquence de relaxation".

On voit donc qu'il n'existe pas à l'heure actuelle de matériau présentant, en hautes fréquences et en hyperfréquences, des valeurs de $\varepsilon'_r$ et $\varepsilon''_r$ suffisamment élevées tout en ayant un rapport $\varepsilon''_r/\varepsilon'_r$ faible (de l'ordre de 0,1).

La présente invention a pour but de remédier aux inconvénients ci-dessus en proposant une composition céramique diélectrique présentant, en hautes fréquences et en hyperfréquences, des valeurs de $\varepsilon'_r$ et $\varepsilon''_r$ élevées et permettant d'avoir un rapport $\varepsilon''_r/\varepsilon'_r$ inférieur à 1 ; les valeurs de $\varepsilon'_r$ peuvent être modulées en fonction du procédé d'élaboration.

Plus précisément, l'invention concerne une composition céramique diélectrique de structure perovskite dérivée de $MTiO_3$, M désignant un métal alcalino-terreux. Selon l'invention, le rapport molaire Ti/M va de 1,01 à 1,10, et de préférence de 1,01 à 1,02. La composition comporte en outre une substance favorisant l'apparition d'une conductivité de type n ainsi qu'une substance formant une couche d'arrêt intergranulaire constituée de $B_2O_3$.

Le fait d'utiliser selon l'invention une céramique de structure perovskite avec un rapport molaire Ti/M allant de 1,01 à 1,10 permet d'améliorer la densification et la permittivité de la céramique.

En effet, lorsque le rapport Ti/M est inférieur à 1,01, la densification est mauvaise, les grains de la céramique sont moins conducteurs et la permittivité apparente de la céramique décroît. Avec des céramiques dont le rapport molaire Ti/M est égal à 1, la permittivité est faible.

Aussi, selon l'invention, on utilise des rapports molaires de Ti/M d'au moins 1,01, ce qui permet d'obtenir les propriétés souhaitées dans le domaine des hautes fréquences et des hyperfréquences.

De préférence, le métal alcalino-terreux est du strontium tandis que la substance favorisant l'apparition d'une conductivité de type n appartient au groupe constitué par $Nb_2O_5$ et $Ta_2O_5$, oxydes habituellement ajoutés pour l'élaboration de céramiques semi-conductrices utilisées aux basses fréquences. La proportion de cette substance dans la composition est de 0,04 à 5% en moles et de préférence de 0,1 à 2% en moles. Au-delà de ces limites, les oxydes $Nb_2O_5$ et $Ta_2O_5$ n'augmentent plus la conductivité globale du grain mais, au contraire, ils élèvent la résistivité du matériau.

L'utilisation du seul oxyde $B_2O_3$ pour former la couche d'arrêt intergranulaire permet d'obtenir une permittivité élevée et de meilleures propriétés dans le domaine des hautes fréquences et des hyperfréquences. En effet, lorsqu'on utilise pour former cette couche un mélange d'oxydes et/ou de carbonates, par exemple des mélanges de $Bi_2O_3$, de $MnO_2$ et de $Li_2CO_3$ comme dans le brevet FR-A-2 339 235, on obtient un fondant très fluide qui pénètre bien aux joints de grains de la céramique semi-conductrice de type perovskite mais qui forme des conducteurs ioniques et donc une couche d'arrêt moins bonne. Par ailleurs, certains ions du mélange d'oxydes et de carbonate peuvent entrer dans la structure perovskite, ce qui n'est pas le cas avec un oxyde tel que $B_2O_3$.

L'invention a également pour objet un procédé de préparation d'une telle composition céramique diélectrique. Selon la principale caractéristique de ce procédé, celui-ci comprend les étapes suivantes :

(a)- mélange d'un carbonate du métal M, d'oxyde de titane $TiO_2$ et d'une substance favorisant l'apparition d'une conductivité de type n, le rapport molaire Ti/M allant de 1,01 à 1,10 et de préférence de 1,01 à 1,02,

(b)- chamottage du mélange afin d'obtenir une poudre de structure perovskite,

(c)- pressage de cette poudre pour obtenir une pastille,

(d)- frittage de cette pastille sous atmosphère réductrice,

(e)- imprégnation de la pastille frittée avec une substance apte à former une couche d'arrêt intergranulaire en $B_2O_3$, et

(f)- réoxydation de la pastille ainsi imprégnée.

Le mot "pastille" utilisé dans la présente description doit être pris dans son sens le plus général et désigne un objet de forme déterminée obtenu par compression et frittage d'une poudre, cet objet pouvant avoir une forme et des dimensions quelconques.

De préférence, le métal M est du strontium et la substance favorisant l'apparition d'une conductivité de type n appartient au groupe constitué par $Nb_2O_5$ et $Ta_2O_5$. Quant à la proportion molaire de cette substance dans le mélange elle va de 0,04 à 5% et de préférence de 0,1 à 2%.

Quant à l'étape (b) de chamottage, elle est de préférence effectuée sous air, à une température comprise entre 800 et 1200°C, pendant une durée comprise entre 5 et 48 heures.

L'étape (d) est réalisée sous atmosphère réductrice, par exemple dans une atmosphère d'azote et d'hydrogène contenant de 0 à 95% d'azote et de 5 à 100% d'hydrogène, ou dans une atmosphère de CO et de $CO_2$ comprenant de 50 à 95% de CO et de 5 à 50% de $CO_2$.

De préférence, le frittage comprend un premier stade effectué à une température de 850 à 1200°C et pendant une durée allant de 1 à 96 heures et un deuxième stade effectué à une température de 1350 à 1500°C, pendant une durée allant de 15 minutes à 24 heures. Il est à noter qu'au cours du frittage, les pastilles subissent une diminution du diamètre Ø, la variation relative $\Delta\emptyset/\emptyset$ étant comprise entre 0,14 et 0,21.

La combinaison de la concentration en dopant n, de l'atmosphère et de la température de frittage permet de moduler à la demande la conduction des grains.

Avantageusement, l'étape (e) d'imprégnation des pastilles se fait en mettant d'abord ladite substance apte à former une couche d'arrêt intergranulaire en suspension dans un liquide volatil et en badigeonnant ensuite la surface de la pastille avec cette suspension.

Quant à l'étape (f) de réoxydation, effectuée généralement à l'air, elle est réalisée de préférence en deux stades, le premier étant effectué à une température de 700 à 1100°C et pendant une durée allant de 10 minutes à 2 heures et un deuxième stade effectué à une température de 1000 à 1350°C et pendant une durée allant de 5 minutes à 2 heures.

De préférence, les étapes (e) et (f) sont répétées au moins une fois.

En effet, l'oxyde $B_2O_3$ est moins fluide que les mélanges d'oxydes et/ou de carbonates utilisés dans l'art antérieur. Aussi, pour former la couche d'arrêt intergranulaire à base de $B_2O_3$, il est préférable de répéter au moins une fois, généralement deux fois, les étapes (e) et (f) d'imprégnation et de réoxydation. On peut de plus utiliser pour ces étapes complémentaires des températures et des durées différentes.

Avec ce procédé, on peut moduler les valeurs de $\varepsilon'_r$ en choisissant de façon appropriée les conditions de réalisation des étapes (b), (d) et (f) par exemple les durées et les températures de frittage et de réoxydation.

L'invention sera mieux comprise à la lecture de la description qui va suivre, donnée à titre purement illustratif et sans aucun caractère de limitation.

On va d'abord donner quelques exemples de réalisation d'une composition céramique diélectrique à l'aide du procédé objet de l'invention.

EXEMPLE 1

Dans cet exemple, on a d'abord mélangé du carbonate de strontium $SrCO_3$, de l'oxyde de titane $TiO_2$ et de l'oxyde de niobium $Nb_2O_5$. La composition du mélange était la suivante : 1

mole de $SrCO_3$, 1,01 mole de $TiO_2$ et 0,025 mole de $Nb_2O_5$.

Ce mélange a d'abord subi un chamottage à l'air pendant une durée de quinze heures à 950°C. Cette opération a permis d'obtenir une poudre de structure perovskite de type $SrTiO_3$. Cette poudre a été pressée afin d'obtenir une pastille "crue".

Les pastilles ont ensuite été frittées sous une atmosphère réductrice contenant 90% d'azote et 10% d'hydrogène. Le frittage a été effectué en deux stades, à savoir : un premier stade de quinze heures à 1000°C suivi d'un deuxième stade de quatre heures à 1455°C. Il est à noter que le premier stade a essentiellement pour but de rendre la poudre très homogène en composition, le deuxième stade constituant le frittage proprement dit.

On a ainsi obtenu une pastille frittée semi-conductrice présentant une variation relative de diamètre $\Delta\emptyset/\emptyset$ de 0,15. Dans tous les exemples décrits ici, les pastilles avaient un diamètre final de l'ordre de 7 mm et une épaisseur de l'ordre de 1 mm.

On a ensuite imprégné ces pastilles avec un fondant composé de $B_2O_3$. Cet oxyde était en suspension dans de l'alcool polyvinylique et a été déposé sur la surface des pastilles à l'aide d'un pinceau. Après évaporation de l'alcool, la pastille imprégnée a subi une réoxydation à l'air pendant 30 minutes à 800°C puis 15 minutes à 1100°C.

Le fait de mettre le fondant en suspension dans un liquide volatil tel que de l'alcool polyvinylique permet une bonne répartition sur la surface des pastilles, donc une imprégnation homogène. Quant à l'étape de réoxydation à l'air, son rôle est d'une part de faire pénétrer le fondant dans les joints de grain afin de former une couche d'arrêt intergranulaire et, d'autre part, de réoxyder partiellement la surface des grains. On obtient ainsi une bonne isolation d'un grain donné par rapport à un grain voisin : en effet, cette isolation est constituée d'abord par la couche superficielle réoxydée du grain considéré, ensuite par la couche d'arrêt intergranulaire et enfin par la couche réoxydée de l'autre grain.

On a ainsi obtenu une céramique diélectrique à couches d'arrêt dont les valeurs de la constante diélectrique réelle $\varepsilon'_r$ sont égales respectivement à $2600\pm100$ à 100 MHz et à $1500\pm200$ à 1 GHz, et des facteurs de pertes $\varepsilon''_r/\varepsilon'_r$ égaux respectivement à $0,25\pm0,02$ à 100 MHz et à $0,55\pm0,10$ à 1 GHz.

## EXEMPLE 2

Dans cet exemple, on a d'abord réalisé un mélange dont la composition molaire était la suivante : 1 mole de carbonate de strontium $SrCO_3$, 1,02 mole d'oxyde de titane $TiO_2$ et 0,0025 mole d'oxyde de niobium $Nb_2O_5$.

Ce mélange a d'abord subi un chamottage à l'air pendant quinze heures à 1000°C. On a obtenu une poudre de structure perovskite de type $SrTiO_3$ qui a été pressée pour obtenir des pastilles, lesquelles ont ensuite subi un frittage sous une atmosphère réductrice contenant 90% d'azote et 10% d'hydrogène.

Ce frittage a été effectué en deux stades : un premier stade de vingt heures à 990°C suivi d'un deuxième stade de deux heures à 1460°C. On a obtenu une pastille frittée semi-conductrice sur laquelle on a observé une diminution relative du diamètre ou retrait $\Delta\emptyset/\emptyset$ de 0,18.

Ces pastilles ont ensuite été imprégnées d'un fondant constitué par de l'oxyde de bore $B_2O_3$ en suspension dans de l'alcool polyvinylique. Les pastilles imprégnées ont été réoxydées à l'air pendant 30 minutes à 800°C puis 15 minutes à 1100°C.

On a obtenu une céramique diélectrique à couches d'arrêt ayant des valeurs de la constante diélectrique réelle $\varepsilon'_r$ égales respectivement à $2900\pm100$ à 100 MHz et à $1700\pm200$ à 1 GHz, et des facteurs de pertes $\varepsilon''_r/\varepsilon'_r$ égaux respectivement à $0,35\pm0,03$ (à 100 MHz) et à $0,24\pm0,10$ (à 1 GHz).

## EXEMPLE 3

Dans cet exemple, on a d'abord réalisé un mélange dont la composition molaire était la suivante : 1 mole de carbonate de strontium $SrCO_3$, 1,02 mole d'oxyde de titane $TiO_2$ et 0,025 mole d'oxyde de niobium $Nb_2O_5$.

Ce mélange a subi un chamottage à l'air de quinze heures à 850°C conduisant à l'obtention d'une poudre de structure perovskite de type $SrTiO_3$. Cette poudre a été pressée afin d'obtenir des pastilles crues qui ont été frittées sous une atmosphère réductrice contenant 90% d'azote et 10% d'hydrogène.

Le frittage a été effectué en deux stades, un premier stade de vingt heures à 1100°C suivi d'un deuxième stade de six heures à 1460°C. Les pastilles frittées semi-conductrices présentaient un retrait $\Delta\emptyset/\emptyset$ égal à 0,18.

Ces pastilles ont ensuite été imprégnées par un fondant composé de $B_2O_3$. Ce fondant était en suspension dans de l'alcool polyvinylique. Les pastilles ont été imprégnées de cette suspension puis, après évaporation de l'alcool, ont subi une réoxydation à l'air effectuée en deux stades : un premier stade de 30 minutes à 850°C et un deuxième stade de 15 minutes à 1080°C. Deux nouvelles imprégnations suivies chacune d'une réoxydation en deux stades de 30 minutes à 800°C, puis de 15 minutes à 1200°C, ont été effectuées en supplément.

On a obtenu une céramique diélectrique à couches d'arrêt présentant des valeurs de la constante diélectrique réelle $\varepsilon'_r$ égales respectivement à $460\pm100$ à 100 MHz et à $380\pm20$ à 1 GHz, et des facteurs de pertes $\varepsilon''_r/\varepsilon'_r$ égaux respectivement à $0,14\pm0,02$ (100 MHz) et à $0,25\pm0,05$ (1 GHz).

## EXEMPLE 4

Dans cet exemple, on a d'abord réalisé un mélange dont la composition molaire était la suivante : 1 mole de carbonate de strontium $SrCO_3$, 1,02 mole d'oxyde de titane $TiO_2$ et 0,0025 mole d'oxyde de niobium $Nb_2O_5$.

Ce mélange a subi un chamottage à l'air de quinze heures à 850°C conduisant à l'obtention d'une poudre de structure perovskite de type $SrTiO_3$. Cette poudre a été pressée afin d'obtenir des pastilles crues qui ont été frittées sous une atmosphère réductrice contenant 90% d'azote et 10% d'hydrogène.

Le frittage a été effectué en deux stades, un premier stade de vingt heures à 1100°C suivi d'un deuxième stade de six heures à 1450°C. Les pastilles frittées semi-conductrices présentaient un retrait $\Delta\emptyset/\emptyset$ égal à 0,15.

Ces pastilles ont ensuite été imprégnées par un fondant de composition $B_2O_3$. Ce fondant était en suspension dans de l'alcool polyvinylique. Les pastilles ont été imprégnées de cette suspension puis, après évaporation de l'alcool, ont subi une réoxydation à l'air effectuée en deux stades : un premier stade de 30 minutes à 800°C et un deuxième stade de 15 minutes à 1300°C.

On a obtenu une céramique diélectrique à couches d'arrêt présentant des valeurs de la constante diélectrique réelle $\varepsilon'_r$ égales respectivement à 1350±10 à 100 MHz et à 450±60 à 1 GHz, et des facteurs de pertes $\varepsilon''_r/\varepsilon'_r$ égaux respectivement à 0,46±0,02 (100 MHz) et à 0,90±0,10 (1 GHz).

## EXEMPLE 5

Dans cet exemple, on a d'abord réalisé un mélange dont la composition molaire était la suivante : 1 mole de carbonate de strontium $SrCO_3$, 1,01 mole d'oxyde de titane $TiO_2$ et 0,025 mole d'oxyde de niobium $Nb_2O_5$.

Ce mélange a subi un chamottage à l'air de quinze heures à 850°C conduisant à l'obtention d'une poudre de structure perovskite de type $SrTiO_3$. Cette poudre a été pressée afin d'obtenir des pastilles crues qui ont été frittées sous une atmosphère réductrice contenant 90% d'azote et 10% d'hydrogène.

Le frittage a été effectué en deux stades, un premier stade de vingt heures à 1100°C suivi d'un deuxième stade de six heures à 1400°C. Les pastilles frittées semi-conductrices présentaient un retrait $\Delta\emptyset/\emptyset$ égal à 0,17.

Ces pastilles ont ensuite été imprégnées par un fondant de composition $B_2O_3$. Ce fondant était en suspension dans de l'alcool polyvinylique. Les pastilles ont été imprégnées de cette suspension puis, après évaporation de l'alcool, ont subi une réoxydation à l'air effectuée en deux stades : un premier stade de 30 minutes à 800°C et un deuxième stade de 15 minutes à 1100°C. Une nouvelle imprégnation a été effectuée en supplément, toujours en deux stades de 30 minutes à 800°C, puis de 15 minutes à 1300°C.

On a obtenu une céramique diélectrique à couches d'arrêt présentant des valeurs de la constante diélectrique réelle $\varepsilon'_r$ égales respectivement à 340±10 à 100 MHz et à 190±20 à 1 GHz, et des facteurs de pertes $\varepsilon''_r/\varepsilon'_r$ égaux respectivement à 0,49±0,02 (100 MHz) et à 0,37±0,05 (1 GHz).

## EXEMPLE COMPARATIF 1

On suit le même mode opératoire que dans l'exemple 5 pour préparer une céramique diélectrique à couches d'arrêt, mais en utilisant comme mélange de départ :
- 1 mole de carbonate de stontium $SrCO_3$,
- 1 mole d'oxyde de titane $TiO_2$, et
- 0,025 mole d'oxyde de niobium $Nb_2O_5$.

On obtient ainsi une céramique diélectrique à couche d'arrêt présentant un retrait de 0,09 et ayant des valeurs de la constante diélectrique réelle $\varepsilon'_r$ égales respectivement à 100 ± 10 à 100 MHz et à 50 ± 10 à 1 GHz, et des facteurs de pertes $\varepsilon''_r/\varepsilon'_r$ égaux respectivement à 0,33 ± 0,02 (à 100 MHz) et à 0,44 ± 0,05 (à 1 GHz).

## EXEMPLE COMPARATIF 2

On suit le même mode opératoire que dans l'exemple 5 pour préparer une céramique diélectrique à couches d'arrêt, mais en utilisant comme mélange de départ :
- 1 mole de carbonate de stontium $SrCO_3$,
- 1,004 mole d'oxyde de titane $TiO_2$, et
- 0,025 mole d'oxyde de niobium $Nb_2O_5$.

On obtient ainsi une céramique diélectrique à couche d'arrêt présentant un retrait de 0,05 et ayant des valeurs de la constante diélectrique réelle $\varepsilon'_r$ égales respectivement à 95 ± 10 à 100 MHz et à 50 ± 10 à 1 GHz, et des facteurs de pertes $\varepsilon''_r/\varepsilon'_r$ égaux respectivement à 0,31 ± 0,02 (à 100 MHz) et à 0,52 ± 0,05 (à 1 GHz).

On remarque ainsi que le fait d'utiliser conformément à l'invention 1,01 à 1,10 mole d'oxyde de titane permet d'améliorer de façon importante la densification de la céramique et ses propriétés diélectriques dans le domaine des hautes fréquences et des hyperfréquences.

Ainsi, l'invention présente des avantages particulièrement intéressants, puisqu'elle permet d'obtenir des compositions céramiques diélectriques ayant des valeurs de $\varepsilon'_r$ et $\varepsilon''_r$ élevées à des fréquences comprises entre le MHz et quelques GHz, le rapport $\varepsilon''_r/\varepsilon'_r$ étant compris entre 0,05 et 0,90. Le procédé permet, à partir de matériaux diélectriques céramiques à couches d'arrêt à base de grains semi-conducteurs, d'obtenir toute une gamme de matériaux présentant des performances diélectriques variables suivant les applications envisagées. En particulier, on peut moduler la conductivité, par suite la valeur de $\varepsilon''_r$ et donc faire varier le rapport $\varepsilon''_r/\varepsilon'_r$.

Dans les essais qui ont été réalisés, on a mesuré $\varepsilon'_r$ et $\varepsilon''_r$ par une méthode de réflexion en guide coaxial. Il s'agit d'une méthode connue en soi et qui ne sera pas décrite en détail ici.

Les matériaux objets de l'invention ont des applications nombreuses et variées. On peut notamment les utiliser pour le revêtement des parois des chambres anéchoïdes (pour des fréquences allant du MHz à quelques GHz), pour réaliser des éléments de protection contre les fuites dans les enceintes micro-ondes, en particulier les fours à micro-ondes (les fréquences utilisées pour ces appareils étant de l'ordre de 2,45 GHz) et pour l'élimination d'interférences et d'échos fixes liés au parasitage de type hyperfréquence, notamment dans les ports.

**Revendications**

1. Composition céramique diélectrique de structure perovskite dérivée de MTiO$_3$, M désignant un métal alcalino-terreux, caractérisée en ce que le rapport molaire Ti/M va de 1,01 à 1,10 et de préférence de 1,01 à 1,02, cette composition comportant en outre une substance favorisant l'apparition d'une conductivité de type n ainsi qu'une substance formant une couche d'arrêt intergranulaire constituée de B$_2$O$_3$.

2. Composition selon la revendication 1, caractérisée en ce que ledit métal alcalino-terreux est du strontium.

3. Composition selon la revendication 1, caractérisée en ce que ladite substance favorisant l'apparition d'une conductivité de type n appartient au groupe constitué par Nb$_2$O$_5$ et Ta$_2$O$_5$.

4. Composition selon la revendication 3, caractérisée en ce que la proportion de ladite substance est de 0,04 à 5% en moles et de préférence de 0,1 à 2% en moles.

5. Procédé de préparation d'une composition céramique diélectrique de structure perovskite dérivée de MTiO$_3$, M désignant un métal alcalino-terreux, caractérisé en ce qu'il comprend les étapes suivantes :

(a)- mélange d'un carbonate du métal M, d'oxyde de titane TiO$_2$ et d'une substance favorisant l'apparition d'une conductivité de type n, le rapport molaire Ti/M allant de 1,01 à 1,10 et de préférence de 1,01 à 1,02,

(b)- chamottage du mélange afin d'obtenir une poudre de structure perovskite,

(c)- pressage de cette poudre pour obtenir une pastille,

(d)- frittage de cette pastille sous atmosphère réductrice,

(e)- imprégnation de la pastille frittée avec une substance apte à former une couche d'arrêt intergranulaire en B$_2$O$_3$, et

(f)- réoxydation de la pastille ainsi imprégnée.

6. Procédé selon la revendication 5, caractérisé en ce que le métal M est du strontium.

7. Procédé selon la revendication 5, caractérisé en ce que ladite substance favorisant l'apparition d'une conductivité de type n appartient au groupe constitué par Nb$_2$O$_5$ et Ta$_2$O$_5$.

8. Procédé selon la revendication 7, caractérisé en ce que la proportion molaire de ladite substance dans le mélange va de 0,04 à 5% et de préférence de 0,1 à 2%.

9. Procédé selon la revendication 5, caractérisé en ce que l'étape (d) comprend un premier stade effectué à une température de 850 à 1200°C et pendant une durée allant de 1 à 96 heures et un deuxième stade effectué à une température de 1350 à 1500°C et pendant une durée allant de 15 minutes à 24 heures.

10. Procédé selon la revendication 5, caractérisé en ce que l'étape (f) comprend un premier stade effectué à une température de 700 à 1100°C et pendant une durée allant de 10 minutes à 2 heures et un deuxième stade effectué à une température de 1000 à 1350°C et pendant une durée allant de 5 minutes à 2 heures.

11. Procédé selon l'une quelconque des revendications 5 à 10, caractérisé en ce que les étapes e) et f) sont répétées au moins une fois.

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| X,P | EP-A-0 261 419  (TDK CORP.)<br>* Revendications 1-7; example 1 *<br><br>--- | 1-5,7-11,13-14 | C 04 B  35/46<br>H 01 B   3/12<br>H 01 G   4/12 |
| X | FR-A-2 508 226  (NORTH AMERICAN PHILIPS)<br>* Revendications 1-13; example 1 *<br>----- | 1-5,7-11,13-14 | |

**DOMAINES TECHNIQUES RECHERCHES (Int. Cl.4)**

C 04 B  35/00
H 01 B   3/00

Le présent rapport a été établi pour toutes les revendications

| Lieu de la recherche | Date d'achèvement de la recherche | Examinateur |
|---|---|---|
| LA HAYE | 19-05-1989 | DROUOT M.C. |